# EUROPEAN PATENT APPLICATION

(11) **EP 4 822 928 A1**
(43) Date of publication of application: **14.10.2026**
(21) Application number: 25170174.4
(22) Date of filing: 11.04.2025
(51) Int. Cl.: H02H 3/05, B60L 53/60, G01R 11/00, H02H 3/20, G01R 22/06

(54) **ELECTRICITY METER FOR METERING POWER CONSUMPTION OF ELECTRICAL EQUIPMENT**

(71) Applicant: HAGER CONTROLS, 67700 Saverne (FR)
(72) Inventor: CALLEGHER, Alexandre, 67330 Ernolsheim-lés-Saverne (FR); CASTELOT, Geoffrey, 67270 Wilwismheim (FR); MONIOT, Frédéric, 67200 Strasbourg (FR); GARTISER, Alain, 57400 Sarrebourg (FR)
(74) Representative: Hagergroup

(57) **Abstract**

The invention relates to an electricity meter (10) for metering a power consumption of an electrical equipment (100), in more particularly of an electric vehicle supply equipment (EVSE). The electricity meter (10) comprises a meter casing (20), a PCB (30) housed in the meter casing (20), a processing unit (32) soldered to the PCB (30), at least one voltage sensor (34) and at least one current sensor (36) housed in the meter casing (20). The electricity meter (10) further comprises a network and system protection device (12) housed in the meter casing (20), the network and system protection device (12) comprising at least one protection device processing unit (14) and at least one protection device voltage sensor (16), the protection device processing unit (14) being configured to control a switch of the electrical equipment (100) based on a voltage value measured by the protection device voltage sensor (16) to disconnect the electrical equipment (100) from a main distribution grid.

## Description

### FIELD OF THE DISCLOSURE

The present disclosure relates to an electricity meter for metering power consumption in electrical equipment, particularly electric vehicle supply equipment (EVSE). Specifically, the disclosure pertains to an electricity meter integrated with a network and system protection device, designed to manage single-phase or three-phase power consumption and ensure safe disconnection from the main distribution grid.

### BACKGROUND OF THE INVENTION

In the field of electricity metering, it is common to utilize electricity meters that measure power consumption for various types of electrical equipment, including residential and industrial applications. These meters are essential for monitoring energy usage and ensuring accurate billing. Known systems typically involve basic metering functionalities that measure voltage, current, and power consumption across single-phase or three-phase electrical systems. Such meters are often integrated into the electrical infrastructure to provide real-time data on energy usage. However, these systems primarily focus on metering and lack advanced features that could enhance the safety and reliability of the electrical equipment they monitor.

Electric vehicle supply equipment (EVSE) represents a growing area of application for electricity meters, as the demand for electric vehicles continues to rise. An example of such an electricity meter is for instance known from WO 2024 173 864 A. More recent EVSE connected to a domestic installation are configured not only to charge a vehicle battery of an electric vehicle but also to discharge the vehicle battery into the domestic installation. These EVSE are often named bidirectional EVSE. Despite the substantial advances in the field of metering technology, existing systems often fall short in addressing the unique requirements of EVSE, in particular bidirectional EVSE. For instance, while traditional meters can measure power consumption, they may not include integrated protection mechanisms to safeguard the electrical equipment from potential faults or grid disturbances or to provide passive or active island detection. This absence of protective features can lead to vulnerabilities in the system, such as overvoltage or undervoltage conditions, which may compromise the safety and efficiency of the equipment or other equipment connected to the same mains utility grid. Additionally, the integration of metering and protection functionalities is typically achieved through separate devices, which can result in increased complexity and cost for installation and maintenance.

Moreover, the reliability of existing network and system protection devices can be compromised due to a lack of redundancy in their design. Redundant systems are crucial for ensuring continuous operation and preventing failures that could disrupt the power supply or damage the equipment. Furthermore, the communication capabilities of traditional meters are often limited, hindering their ability to interact with other devices or systems for configuration and monitoring purposes. This limitation can affect the adaptability of the metering system to evolving grid codes and standards, which are essential for maintaining compliance and optimizing performance.

Despite the substantial advances in the field of electricity metering, there remains a need for improved systems that integrate advanced protection features, enhance reliability through redundancy, and offer robust communication capabilities. It is therefore a technical problem underlying the present invention to provide an electricity metering system that at least partially overcomes the disadvantages of known systems.

### SUMMARY OF THE DISCLOSURE

It is an object of this invention to provide a device that overcomes one or more of the disadvantages of known systems.

A first aspect of the invention provides electricity meter for metering a single phase power consumption or a three-phase power consumption of an electrical equipment, in particular of an electric vehicle supply equipment and configured to be installed in a receiving section of the electrical equipment, the electricity meter comprising a meter casing, a printed circuit board (PCB) housed in the meter casing, a meter processing unit soldered to the PCB, at least one meter voltage sensor housed in the meter casing, at least one meter current sensor housed in the meter casing, a neutral meter connection terminal configured to be connected to a neutral connection terminal of the electrical equipment , at least one input phase meter connection terminal configured to be connected to an input phase connection terminal of the electrical equipment and at least one output phase meter connection terminal configured to be connected to an output phase connection terminal of the electrical equipment, characterized by a network and system protection device housed in the meter casing, the network and system protection device comprising at least one protection device processing unit and at least one protection device voltage sensor, the protection device processing unit being configured to control a switch of the electrical equipment based on a voltage value measured by the protection device voltage sensor to disconnect the electrical equipment from a main distribution grid.

The electricity meter according to the first aspect is designed for measuring the power consumption of the electrical equipment, such as the electric vehicle supply equipment (EVSE), in either single-phase or three-phase configurations. This electricity meter is intended to be installed within a designated section of the electrical equipment. The meter includes several components housed within the meter casing: the printed circuit board (PCB) to which the meter processing unit is soldered, voltage and current sensors, and various connection terminals for interfacing with the electrical equipment.

The meter casing houses the printed circuit board (PCB) that serves as the foundation for the meter's electronic components. The meter processing unit, which is soldered to the PCB, is responsible for processing the data collected by the sensors. The voltage and current sensors measure the electrical parameters necessary for determining power consumption. The neutral meter connection terminal is designed to connect to the neutral terminal of the electrical equipment, while the input and output phase meter connection terminals connect to the corresponding phase terminals of the electrical equipment.

A distinguishing feature of this electricity meter is the inclusion of the network and system protection device within the meter casing. This protection device comprises its own processing unit and voltage sensor. The protection device processing unit controls a switch in the electrical equipment based on the voltage measurements taken by the protection device voltage sensor. This functionality allows the protection device to disconnect the electrical equipment from the main distribution grid if necessary, enhancing safety and preventing potential damage to the system. The network and system protection device may also be referred to as NS-protection or "NA-Schutz" in German language.

The advantages of this claimed subject matter include the integration of metering and protection functionalities within a single device, which simplifies installation and reduces the need for separate protective equipment. The ability to disconnect the electrical equipment from the main distribution grid based on real-time voltage measurements ensures a higher level of system protection and reliability, particularly in applications involving electric vehicle supply equipment.

In a preferred embodiment of the first aspect, the protection device processing unit and the protection device voltage sensor are soldered to the PCB, in particular to a section of the PCB which is functionally independent of the meter processing unit, the meter voltage sensor and the meter current sensor.

The preferred embodiment introduces an enhancement by specifying that the protection device processing unit and the protection device voltage sensor are soldered to the printed circuit board of the electricity meter. Notably, these components are positioned on a section of the printed circuit board that is functionally independent from the meter processing unit, the meter voltage sensor, and the meter current sensor. This separation of functional areas on the printed circuit board is significant because it allows for the protection device to operate independently of the metering functions, potentially increasing the reliability and effectiveness of the protection mechanisms. By soldering the protection device components directly onto the printed circuit board, the design ensures robust communication and integration between the protection device processing unit and its associated voltage sensor, while maintaining a clear division from the metering components. This configuration may enhance the overall functionality of the electricity meter by providing a dedicated pathway for the protection device to perform its critical role without interference from the metering processes. Hence, the separation of functional areas on the printed circuit board further permits the metering function and the protection function to be certified independently from one another. Furthermore, the electricity meter may be certified as a separate unit before its installation in the electrical equipment, as for instance stipulated in Article 5 of the Measuring Instruments Directive 2014/32/EU. The soldering of these components onto the printed circuit board also suggests a compact and efficient design, which could be advantageous in terms of manufacturing and installation within the electrical equipment. Overall, this embodiment highlights the thoughtful integration of protection mechanisms within the electricity meter, ensuring that the device can effectively safeguard the electrical equipment from potential voltage-related issues while simultaneously performing its primary metering functions.

In a preferred embodiment of the first aspect, the electricity meter further comprises a meter screen unit configured to display the momentary power consumption of the electrical.

The preferred embodiment introduces new features that enhance the functionality and user interface of the electricity meter. Specifically, it includes a meter screen unit designed to display the momentary power consumption of the electrical equipment, thereby providing real-time feedback to the user regarding energy usage. Furthermore, the network and system protection device can be equipped with a second screen unit that displays information pertinent to the operation and status of the protection device. This second screen unit allows users to monitor the functionality of the protection device, ensuring that it is operating correctly and providing necessary protection to the electrical equipment. The inclusion of these screen units facilitates improved communication between the meter's components and the user, offering a more comprehensive and user-friendly interface. The meter screen unit and the second screen unit bring significant new features by enhancing the visibility and accessibility of critical information, thereby improving the overall user experience and operational transparency of the electricity meter.

In a preferred embodiment of the first aspect, the network and system protection device further comprises a memory unit configured to store information relative to a grid code of the main distribution grid and to which the protection device processing unit has access to.

This preferred embodiment introduces a significant advancement in the functionality and reliability of the electricity meter by enabling it to adhere to specific regulations and standards set forth by the grid code. A specific country or region may require a given grid code which can be different than the grid code of another country or region. The grid code typically encompasses rules and requirements regarding the operation, performance, and interaction of electrical equipment with the main distribution grid, ensuring that the equipment operates within safe and efficient parameters. By incorporating a memory unit to store this information, the electricity meter can dynamically adjust its operations based on the grid code, thereby enhancing its ability to protect both the electrical equipment and the grid itself. The protection device processing unit, having access to the stored grid code information, can make informed decisions to control the switch of the electrical equipment. This control mechanism is based on the voltage value measured by the protection device voltage sensor, allowing the processing unit to disconnect the electrical equipment from the main distribution grid when necessary, for instance when the measured voltage and/or a measured frequency of the voltage go(es) beyond a predetermined acceptable voltage range and/or frequency range set for the grid code. This disconnection is crucial in preventing potential damage to the electrical equipment and mitigating risks such as overvoltage, undervoltage, or other anomalies that may arise within the grid. The communication between the memory unit and the protection device processing unit ensures that the electricity meter can continuously monitor and respond to changes in the grid conditions, maintaining compliance with the grid code and optimizing the safety and efficiency of the electrical equipment. Furthermore, this feature enhances the adaptability of the electricity meter, making it suitable for various applications, including electric vehicle supply equipment, where adherence to grid codes is essential for safe and reliable operation, especially in a bidirectional mode. The integration of the memory unit and its interaction with the protection device processing unit exemplifies a sophisticated approach to grid protection, elevating the overall functionality of the electricity meter and providing a robust solution for managing power consumption and safeguarding electrical systems.

In a further preferred embodiment of the first aspect, the network and system protection device further comprises a data interface configured to communicate with a configuration device of the network and system protection device.

The preferred embodiment introduces an additional feature to this configuration by incorporating the data interface within the network and system protection device. This data interface is specifically configured to communicate with the configuration device associated with the network and system protection device. The introduction of this data interface brings several advantages and new functionalities to the electricity meter. Primarily, it facilitates enhanced communication capabilities between the network and system protection device and external configuration devices. This communication mechanism allows for the transmission and reception of data, enabling configuration, monitoring, and management of the protection device's settings and operations. By integrating this data interface, the electricity meter can support advanced functionalities such as firmware updates, real-time data analysis, and diagnostics, which can significantly improve the efficiency and reliability of the electrical equipment's operation. Furthermore, the data interface enhances the adaptability of the protection device, allowing it to be configured to meet specific requirements, respond to changing conditions in the electrical grid or adapt its functions to a different grid code. This feature is particularly beneficial in dynamic environments where grid conditions may fluctuate, necessitating rapid adjustments to ensure optimal performance and safety. Overall, the inclusion of the data interface in the network and system protection device represents a significant advancement in the design and functionality of the electricity meter, offering improved communication, configurability, and operational flexibility that can contribute to more efficient and secure management of power consumption and protection of electrical equipment.

In a further preferred embodiment of the first aspect, the network and system protection device comprises at least two redundant protection device processing units.

In this embodiment, the specific mechanisms of communication between components include the interaction between the protection device processing unit and the switch of the electrical equipment, which is controlled based on the voltage value measured by the protection device voltage sensor. The inclusion of at least two redundant protection device processing units introduces a significant enhancement in the reliability and safety of the network and system protection device. Redundancy in the protection device processing units ensures that if one processing unit fails, the other can take over its functions, thereby maintaining continuous protection and operational integrity. This redundancy is particularly crucial in scenarios where uninterrupted power supply and protection are essential, such as in electric vehicle supply equipment. The redundant protection device processing units work in tandem to monitor and control the voltage and switching mechanisms, providing a fail-safe operation that mitigates the risk of single-point failures. This feature brings an added layer of security and reliability to the electricity meter, ensuring that the electrical equipment remains protected under varying conditions and potential faults. The redundancy also enhances the overall robustness of the system, making it more resilient to hardware malfunctions and ensuring consistent performance in metering and protection tasks.

In a further preferred embodiment of the first aspect, the network and system protection device comprises at least two redundant protection device voltage sensors, in particular two redundant protection device voltage sensors for each current phase.

In this embodiment, the inclusion of redundant protection device voltage sensors introduces a significant enhancement in the reliability and safety of the electricity meter. By having at least two redundant sensors for each current phase, the system ensures that voltage measurements are cross-verified, thereby reducing the likelihood of erroneous readings that could lead to improper functioning or failure of the protection mechanism. This redundancy is particularly crucial in scenarios where accurate voltage measurement is imperative for the safe disconnection of the electrical equipment from the main distribution grid. The redundant sensors provide a fail-safe mechanism, ensuring that even if one sensor fails or provides inaccurate data, the other sensor can still provide the necessary voltage information to the protection device processing unit. This dual-sensor configuration enhances the robustness of the network and system protection device, thereby improving the overall reliability and safety of the electricity meter in critical applications such as electric vehicle supply equipment.

In a further preferred embodiment of the first aspect, the meter housing provides at least IP51 protection when installed in the electrical equipment.

The preferred embodiment introduces a new feature, specifying that the meter housing provides at least IP51 protection when installed in the electrical equipment. IP51 stands for an ingress protection code according to the international standard IEC 60529. This enhancement ensures that the meter housing is protected against dust ingress to a degree that prevents interference with the meter's operation, and against vertically dripping water, which could otherwise compromise the meter's functionality. The IP51 rating signifies a robust level of protection, making the electricity meter suitable for environments where exposure to dust and moisture is a concern. This feature is particularly beneficial for outdoor installations or in settings where environmental conditions may vary, thereby extending the durability and reliability of the meter. The communication mechanisms between the components within the meter are crucial for its operation. The meter processing unit communicates with the voltage and current sensors to accurately measure power consumption, while the protection device processing unit interacts with its voltage sensor to monitor the electrical system's status. Upon detecting voltage anomalies, the protection device processing unit sends signals to control the switch, effectively disconnecting the equipment from the grid to prevent damage or hazards. The integration of these communication mechanisms ensures that the meter not only measures power consumption but also actively contributes to system safety and reliability. The addition of IP51 protection further enhances the meter's capability to withstand adverse conditions, making it a versatile and dependable choice for various applications.

In a further preferred embodiment of the first aspect, the electricity meter is an electricity meter which is certified according to the Measuring Instrument Directive (MID), in particular according to the Measuring Instrument Directive 2014/32/EU. Alternatively or additionally, the electricity meter can also be certified according to the German "Mess- und Eichgesetz".

The MID certification enhances the functionality of the electricity meter by ensuring that all components, including the meter processing unit, voltage sensors, current sensors, and protection device, operate within the parameters defined by the directive. This certification also implies that the electricity meter has undergone rigorous testing and validation processes, including electromagnetic compatibility tests, environmental tests, and accuracy tests, to meet the MID standards. Consequently, the MID-certified electricity meter provides a reliable and standardized solution for metering single-phase or three-phase power consumption, particularly in electric vehicle supply equipment (EVSE). The certification also facilitates interoperability with other MID-certified devices and systems, ensuring seamless integration into existing energy management infrastructures.

A second aspect of the invention provides an electrical equipment, in particular an electric vehicle supply equipment comprising an electricity meter according to the first aspect, a receiving section, a neutral connection terminal, at least one input phase connection terminal and at least one output phase connection terminal, the electricity meter being installed in the receiving section, the neutral meter connection terminal of the electricity meter being connected to the neutral connection terminal, the input phase meter connection terminal of the electricity meter being connected to the input phase connection terminal and the output phase meter connection terminal of the electricity meter being connected to the output phase connection terminal.

The specific mechanisms of communication between components in this embodiment involve the direct connections between the neutral meter connection terminal and the neutral connection terminal, the input phase meter connection terminals and the input phase connection terminals, and the output phase meter connection terminals and the output phase connection terminals. These connections facilitate the seamless integration of the electricity meter within the electrical equipment, ensuring accurate metering of power consumption and effective protection of the electrical system. The new features introduced by this embodiment enhance the functionality and reliability of the electrical equipment by incorporating the network and system protection device within the meter casing. This integration allows for real-time monitoring and control of the electrical equipment, ensuring that it can be safely disconnected from the main distribution grid in response to voltage anomalies. The protection device processing unit and voltage sensor work in tandem to provide a robust mechanism for safeguarding the electrical equipment and the broader electrical network. By embedding these components within the electricity meter, the embodiment offers a compact and efficient solution for managing power consumption and protecting electrical systems, particularly in the context of electric vehicle supply equipment.

### BRIEF DESCRIPTION OF THE DRAWINGS

Figure 1: shows an perspective view of an electricity meter according an embodiment with a casing, screen units, and connection terminals.
Figure 2: shows a front view of the electricity meter according to the embodiment.
Figure 3: shows a lateral view of the electricity meter according to the embodiment.
Figure 4: shows a rear view of the electricity meter according to the embodiment.
Figure 5: shows an exploded view of an electrical equipment comprising the electricity according to the embodiment.
Figure 6: shows a cross sectional view of the electricity meter according to the embodiment installed in the electrical equipment.
Figure 7: shows a further cross sectional view of the electricity meter according to the embodiment installed in the electrical equipment.
Figure 8: shows a detailed view of the electricity meter according to the embodiment.
Figure 9: shows a schematic block diagram of the electricity meter according to the embodiment.

### DETAILED DESCRIPTION OF THE EMBODIMENTS

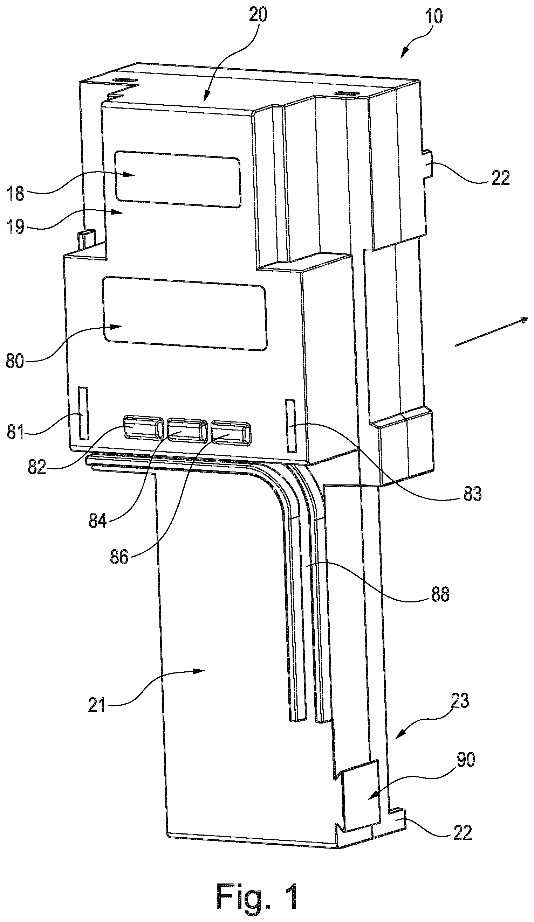

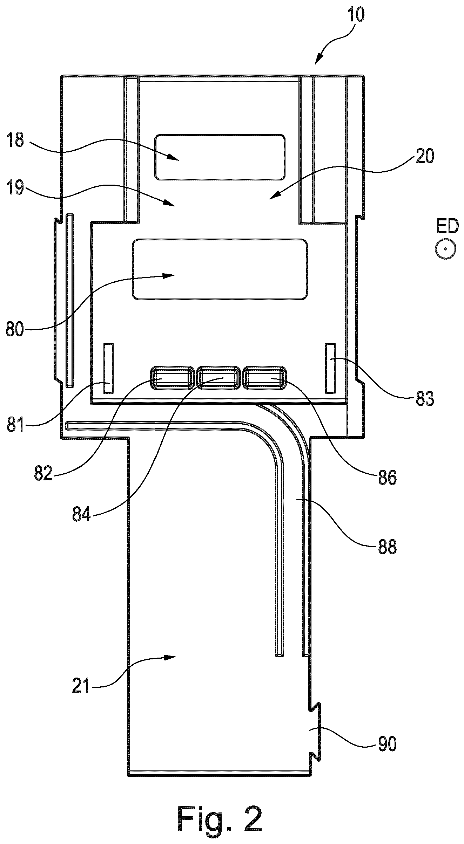

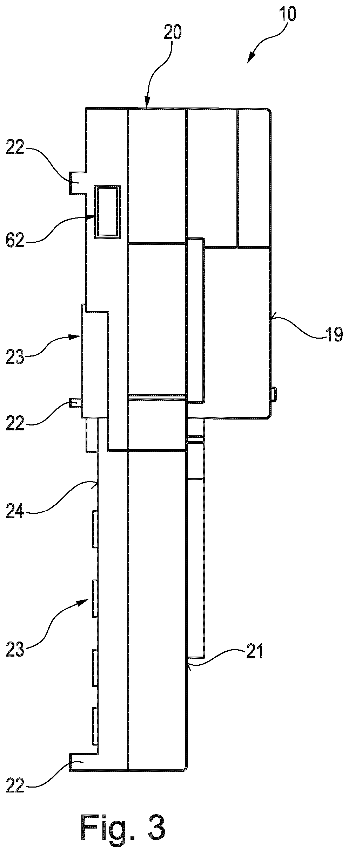

Figures 1 to 4 illustrate an electricity meter 10 according to a preferred embodiment of the invention, designed for metering single-phase or three-phase power consumption of electrical equipment 100, specifically an electric vehicle supply equipment EVSE. The electricity meter 10 is housed within a meter casing 20, which provides structural protection and mounting capabilities.

A notable feature of the embodiment is the inclusion of a network and system protection device 12 housed within the meter casing 20. This device comprises at least one protection device processing unit 14 and at least one protection device voltage sensor 16. The protection device processing unit 14 is configured to control a switch of the electrical equipment 100 based on the voltage value measured by the protection device voltage sensor 16, thereby enabling the disconnection of the electrical equipment 100 from the main distribution grid when necessary. More particularly, the processing unit 14 can be configured to open the switch of the electrical equipment 100 when the measured voltage value drops out of a predefined voltage range and/or open the switch of the electrical equipment 100 when a current frequency determined by the protection device processing unit 14 based on several subsequent measured voltages value drops out of a predefined frequency range. This switch is responsible for disconnecting the electrical equipment 100 from the main distribution grid based on the voltage measurements made by the protection device voltage sensor 16, ensuring system protection and compliance with grid codes. The network and system protection device 12 may provide passive and/or active island protection. This is particularly beneficial when the electrical equipment 100, in which the electricity meter 10 is installed, is a bidirectional EVSE, which needs to cut off from the mains electricity grid, when the current injected into the mains electricity grid is not in conformity with the grid code. The network and system protection device 12 may also be referred to as NS-protection or "NA-Schutz" in German language.

The network and system protection device 12 further comprises a memory unit configured to store information related to a grid code of the main distribution grid, which the protection device processing unit 14 can access. A specific country or region may require a given grid code which can be different than the grid code of another country or region. The grid code can comprise the mentioned predefined voltage range and/or open the mentioned predefined frequency range. Moreover, the network and system protection device 12 includes one data interface, more particularly a wireless data interface, which is configured to communicate with a configuration device of the network and system protection device. This data interface allows for the configuration and monitoring of the network and system protection device 12, ensuring it operates correctly and efficiently. The grid code can be set during the installation of the electrical equipment 100 or the electricity meter 10 by an installer through the data interface.

In terms of redundancy, the network and system protection device 12 is equipped with at least two redundant protection device processing units 14 and at least two redundant protection device voltage sensors 16, with two redundant protection device voltage sensors 16 for each current phase.

The casing 20 is structured to facilitate installation within a designated receiving section 120 of the electrical equipment 100, aligning with an engagement direction ED. The meter casing 20 features a support section, which protrudes in the engagement direction ED. Preferably, the support section is formed by a plurality of support feet 22. The support feet 22 may be separated from one another by gaps 23. This support section is configured to rest against a receiving section 120 when the electricity meter 10 is installed, ensuring stability and proper alignment. The engagement direction ED is substantially orthogonal to a receiving surface 122 of the electrical equipment 100, facilitating straightforward linear motion during installation.

The electricity meter 10 further comprises a printed circuit board (PCB) 30 housed in the meter casing 20, a meter processing unit 32 soldered to the PCB 30, at least one meter voltage sensor 34 housed in the meter casing 20, at least one meter current sensor 36 housed in the meter casing 20, a neutral meter connection terminal 38 configured to be connected to a neutral connection terminal 138 of the electrical equipment 100 , at least one input phase meter connection terminal 40, 42, 44 configured to be connected to an input phase connection terminal 140, 142, 144 of the electrical equipment 100 and at least one output phase meter connection terminal 41, 43, 45 configured to be connected to an output phase connection terminal 141, 143, 145 of the electrical equipment 100. The meter voltage sensor 34 and the meter current sensor 36 typically provide an analog signal which is representative of the measured voltage and/or current.

The electricity meter 10 may further comprise an analog to digital converter 35 connected to the meter voltage sensor 34 and the meter current sensor 36 on the one hand and to the meter processing unit 32 on the other hand. The analog to digital converter 35 retrieves analog data from the meter voltage sensor 34 and/or the meter current sensor 36 and provides a digital representation of the measurements to the meter processing unit 32. The analog to digital converter 35 is typically also soldered to the PCB 30.

The protection device processing unit 14 and the protection device voltage sensor 16 are also soldered to the PCB 30, specifically to a section of the PCB 30 that is functionally independent of the meter processing unit 32, the meter voltage sensor 34, and the meter current sensor 36.

The electricity meter 10 according to the embodiment is a three-phase electricity meter that is configured for metering a three-phase power consumption of the electrical equipment 100. The electricity meter 10 according to the embodiment hence comprises three meter voltage sensors 34, three meter current sensors 36, that is one meter voltage sensor 34 and one meter current sensor 36 for each phase. The electricity meter 10 according to the embodiment also comprises three input phase meter connection terminal 40, 42, 44 and three output phase meter connection terminals 41, 43, 45.

The meter casing 20 includes a front panel 19 and a lower section 21. The front panel 19 features multiple display units and operational buttons. The electricity meter 10 comprises a meter screen unit 80 which is prominently positioned on the front panel 19 and configured to display the power consumption of the electrical equipment 10 in real time. The meter screen unit 80 provides users with immediate visual feedback regarding the electricity usage of the connected electrical equipment 100. Adjacent to the meter screen unit 80 is the second screen unit 18, which is part of the network and system protection device 12 and displays information relative to the function of the network and system protection device 12.

Below the screen units 18, 80, the front panel 19 includes several push-buttons 82, 84, 86, namely push-button 82, push-button 84, and push-button 86, which facilitate user interaction with the electricity meter's 10 functionalities. Typically, the push-buttons 82, 84, 86 allow the input of commands to the electricity meter 10, more particularly commands to toggle between different data to be displayed on the meter screen unit 80. For instance, the different data to be displayed can be the momentary voltage on a particular phase, momentary current on a particular phase, the momentary active energy for a particular phase, the momentary active energy for all phases combined, the momentary active power and/or the momentary reactive power. Additional data can be the serial number of the electricity meter, the date and/or the year of the calibration of the electricity meter 10, the version number of the software running on the meter processing unit 32, etc... Indicator lights 81, 83 are also present to indicate operational status of the electricity meter 10 and provide visual feedback to the user.

The lower section 21 of the meter casing 20 houses the connection terminals. The neutral meter connection terminal 38, input phase meter connection terminals 40, 42, 44, and output phase meter connection terminals 41, 43, 45 are located here, providing connectivity to the corresponding terminals of the electrical equipment 100. These terminals are designed to ensure secure and reliable electrical connections.

The meter casing 20 is designed to provide at least IP51 protection, ensuring that the internal components are safeguarded against dust ingress and limited water exposure. This level of protection is beneficial for maintaining the integrity and functionality of the electricity meter 10 in various environmental conditions.

The electricity meter 10 is certified according to the Measurement Instrument Directive MID, as indicated by the certification mark on the front panel 19. This certification ensures that the electricity meter 10 meets accuracy and reliability standards required for commercial and industrial applications.

The figure also shows a wiring channel 88, which organizes and protects additional electrical wires connecting the electricity meter 10 to the electrical equipment. This wiring channel 88 facilitates electrical connections between an auxiliary data interface 62 of the electricity meter 10 and an auxiliary device of the electricity meter 10, ensuring the transmission of data signals between the electricity meter 10 and the auxiliary device. The wiring channel 88 ensures that the connections are neat and reduces the risk of accidental disconnections or damage to the wires.

The casing 20 is further detailed with an attachment portion 90, which is configured to receive the auxiliary device. This ensures that auxiliary device is securely positioned on the casing 20 of the electricity meter 10.

The electricity meter 10 is designed to provide robust protection and accurate measurement capabilities. The meter casing 20 ensures that the internal components are protected from environmental factors, providing at least IP51 protection when installed in the electrical equipment. This level of protection indicates that the meter casing is dust-protected and can withstand dripping water, making it suitable for various installation environments.

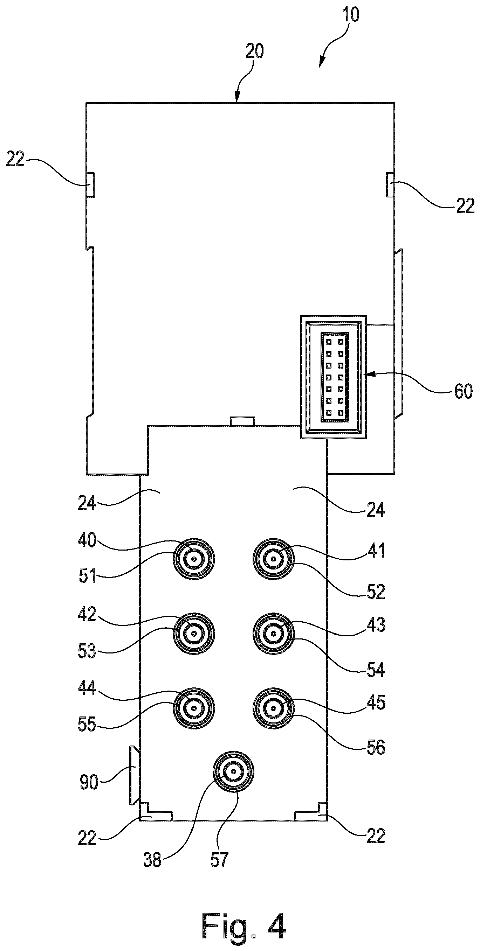

As depicted in figure 4 in particular, the electricity meter 10 includes multiple connection terminals for interfacing with the electrical equipment 100. These terminals are arranged in two vertical rows on the lower section 21 of the meter casing 20. The left row comprises the input phase meter connection terminals 40, 42, 44, and the right row comprises the corresponding output phase meter connection terminals 41, 43, 45. Additionally, the neutral meter connection terminal 38 is positioned at the bottom center, flanked by support feet 22. The meter casing 20 further comprises multiple openings 51, 52, 53, 54, 55, 56, 57, which are designed to be penetrated by the corresponding connection terminals 140, 141, 142, 143, 144, 145 of the electrical equipment 100 when the electricity meter 10 is installed. These openings ensure that the neutral meter connection terminal 38, input phase meter connection terminals 40, 42, 44, and output phase meter connection terminals 41, 43, 45 are electrically connected to their respective terminals140, 141, 142, 143, 144, 145 of the electrical equipment 100.

As can be further seen in figure 4, the electricity meter 10 is equipped with a meter data connection interface 60, which is arranged on the back surface 24. The data connection interface 60 is designed to connect to a corresponding data connection interface 160 of the electrical equipment 100 by the same linear motion in the engagement direction ED, by which the neutral meter connection terminal 38, the input phase meter connection terminal 40, 42, 44 and the output phase meter connection terminal 41, 43, 45 are connected to the neutral connection terminal 138, the input phase connection terminal 140, 142, 144 and the output phase connection terminal 141, 143, 145 of the electrical equipment 100.

Overall, Figures 1 to 4 provide a comprehensive view of the electricity meter 10, highlighting its key components, their arrangement, and the functionalities they support. The design ensures ease of installation, user interaction, and reliable operation in metering power consumption and protecting the electrical system.

The electricity meter 10 is designed to integrate seamlessly within the receiving section of the EVSE, with all connection terminals and interfaces positioned for easy access and secure attachment. The meter casing 20 provides protection for the internal components, ensuring durability and reliability in various environmental conditions.

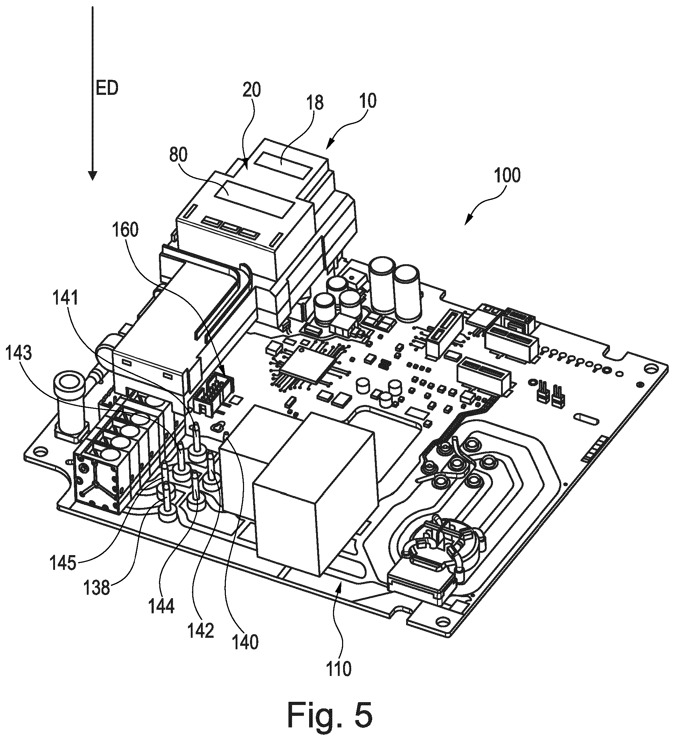

Figure 5 depicts an exploded view of the embodiment of the electricity meter 10 integrated within the electrical equipment 100. The receiving section 120 of the electrical equipment 100 includes the receiving surface 122, which provides a structural interface for the meter casing 20. The engagement direction ED indicates the linear motion required for installation, which is substantially orthogonal to the receiving surface 122.

The meter casing 20 contains the printed circuit board PCB 30, which serves as the foundation for various components contributing to the electricity meter's 10 operation. The PCB 30 is populated with a processing unit, which is responsible for executing metering functions and processing data from sensors.

The meter casing 20 accommodates the meter processing unit 32, which is responsible for processing the data received from the meter voltage sensor(s) 34 and the meter current sensor(s) 36. The meter screen unit 80 is positioned on the meter casing 20, providing a display interface for users to view momentary power consumption data of the connected electrical equipment 100. Adjacent to the meter screen unit 80 is the second screen unit 18, which displays information pertinent to the network and system protection device 12.

The electrical equipment 100 comprises a printed circuit board (PCB) 110 to which the neutral connection terminal 138, the input phase connection terminals 140, 142, 144 and the output phase connection terminals 141, 143, 145 are soldered to.

The electrical equipment 100 may be provided with a cover (not represented in the figures) covering at least the electricity meter 10 and/or other components of the electrical equipment 100. The cover may be fixed to a part of the electrical equipment 100, for instance a housing of the electrical equipment 100 in a tamper proof manner. For that matter, the cover may fixed using screws each provided with a tamper proof screw cap or varnish.

As shown in Figure 5, the data connection interface 60 of the electricity meter 10 is designed to connect to the corresponding data connection interface 160 of the electrical equipment 100 by the same linear motion in the engagement direction ED.

In summary, Figure 5 provides a detailed schematic of the electricity meter 10 and its integration within the electrical equipment 100, showcasing the structural and functional components necessary for effective connectivity. The design emphasizes ease of installation, reliable electrical connections, and efficient data communication, making it suitable for applications such as electric vehicle supply equipment EVSE.

Electrical connections are facilitated through various terminals. The neutral meter connection terminal 138 is designed to connect to the neutral connection terminal of the electrical equipment 100. Input phase meter connection terminals 140, 142, and 144 are configured to connect to corresponding input phase connection terminals of the equipment. Similarly, output phase meter connection terminals 141, 143, and 145 are provided for connection to the output phase terminals of the electrical equipment 100.

The embodiment of the electricity meter 10 showcases a robust design that integrates metering and protection functionalities within a single unit. The electricity meter 10 is engineered to provide accurate power consumption data while ensuring the safety and compliance of the connected electrical equipment 100 with grid standards. The detailed layout and component integration highlight the technical sophistication and practical application of the electricity meter in modern electrical systems.

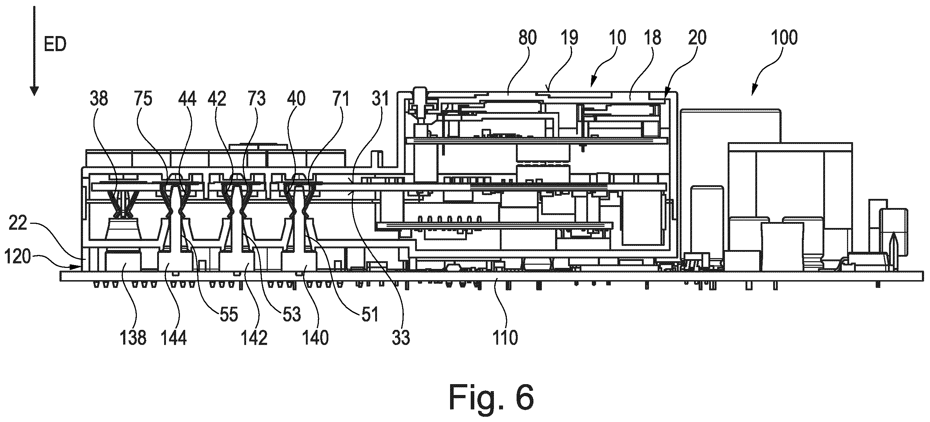

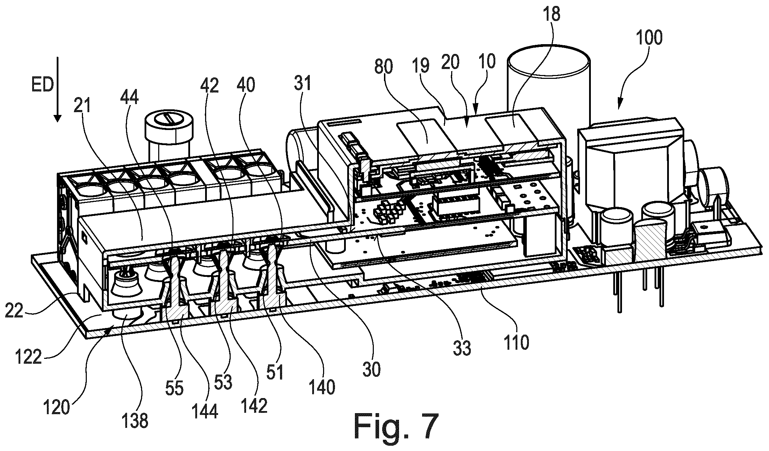

Figures 6 and 7 show cross sectional views of the electricity meter 10 installed in the receiving section 120. The support section of the meter casing 20 rests against the receiving surface 122 when installed. The engagement direction ED is indicated, showing the linear motion required for installation.

Figure 6 shows the neutral meter connection terminal 38 of the electricity meter 10 connected to the neutral connection terminal 138, the input phase meter connection terminals 40, 42, 44 of the electricity meter 10 connected to the input phase connection terminals 140, 142, 144 and the output phase meter connection terminals 41, 43, 45 of the electricity meter 10 connected to the output phase connection terminal 141, 143, 145.

The neutral meter connection terminal 38, input phase meter connection terminals 40, 42, 44, and output phase meter connection terminals 41, 43, 45 are formed as crown spring connectors, providing secure and reliable connections. Each crown spring connector comprises a base in a sleeve shape and a plurality of contacting tongues configured to come in contact with the connection terminals 140, 141, 142, 143, 144, 145 of the electrical equipment 100. The contacting tongues protrude from the base of the crown spring connector and are preferably arranged circumferentially around the base in a funnel shape. Each crown spring connector is designed to provide reliable and efficient electrical connections through a springloaded mechanism formed by the contacting tongues. The use of crown spring connectors provides several advantages, including enhanced contact stability and reduced risk of disconnection due to vibrations or mechanical stresses. Crown spring connectors are known for their ability to maintain consistent electrical contact even under varying environmental conditions, which is particularly beneficial for applications involving EVSE that may be subject to changes in the environmental conditions. Additionally, the use of crown spring connectors simplifies the installation process by allowing for straightforward linear engagement, thereby reducing the complexity and time required for connecting the electricity meter 10 to the electrical equipment 100. This improvement in connector design ensures that the electricity meter 10 can be securely and efficiently integrated into the receiving section 120 of the electrical equipment 100, providing reliable metering of power consumption. Furthermore, the crown spring connectors contribute to the overall durability and longevity of the electricity meter 10 by minimizing wear and tear on the connection points, which can be a critical factor in maintaining accurate and consistent metering performance over extended periods.

Additionally, the printed circuit board PCB 30 within the meter casing 20 comprises orifices 71, 72, 73, 74, 75, 76, 77, which are configured to be penetrated by the neutral connection terminal 138, input phase connection terminals 140, 142, 144, and output phase connection terminals 141; 143, 145 of the electrical equipment 100. The connection terminals 140, 141, 142, 143, 144, 145 are positioned coaxially with these orifices71, 72, 73, 74, 75, 76, 77 and protrude through them, ensuring proper alignment and connection.

The connection terminals are soldered to the PCB on the side 31 facing away from the back surface 24 and the receiving surface 122 of the electrical equipment 100, further securing the connections. The connection terminals 140, 141, 142, 143, 144, 145 protrude from a side 33 of the PCB facing the back surface 24 and the receiving surface 122 through the orifices 71, 72, 73, 74, 75, 76, 77 towards the side 31 of the PCB facing away from the back surface 24 and the receiving surface 122.

As depicted in figures 6 and 7, the neutral meter connection terminal 38 and input phase meter connection terminals 40, 42, 44 are positioned coaxially with their respective orifices 71, 73, 75, 77 on the PCB 30. Additionally, the output phase meter connection terminals 41, 43, 45 are positioned coaxially with their respective orifices 72, 74, 76. These terminals are configured as crown spring connectors, which allow for secure electrical connections when engaged with the corresponding connection terminals of the electrical equipment 100. The connection terminals 140, 141, 142, 143, 144, 145, 146 of the electrical equipment 100 are each formed by a connection pin extending in a direction which is parallel to the engagement direction ED, facilitating the linear motion required for installation. In the installed position of the electricity meter 10 in the electrical equipment 100 depicted in figure 6, the connection pins are housed in the crown spring connectors. The meter connection terminals 40, 41, 42, 43, 44, 45, 46 are soldered to the PCB 30 on the side 31 facing away from the back surface 24 of the meter casing 20. The connection terminals 140, 141, 142, 143, 144, 145, 146 of the electrical equipment 100 are each soldered to the PCB 110 of the electrical equipment 100.

The PCB 30 depicted in figures 6 and 7 also shows the meter processing unit 32, which is soldered to the PCB 30 and responsible for processing the metering data. The meter data connection interface 60, which is preferably arranged on the back surface 24, is configured to connect to a data connection interface 160 of the electrical equipment 100 through the same linear motion in the engagement direction ED.

The electricity meter 10 provides ease of installation and reliability, utilizing crown spring connectors for the connection terminals, which offer flexibility and durability. The linear motion installation mechanism ensures that the meter can be easily integrated into the electrical equipment 100 without the need for complex adjustments or configurations.

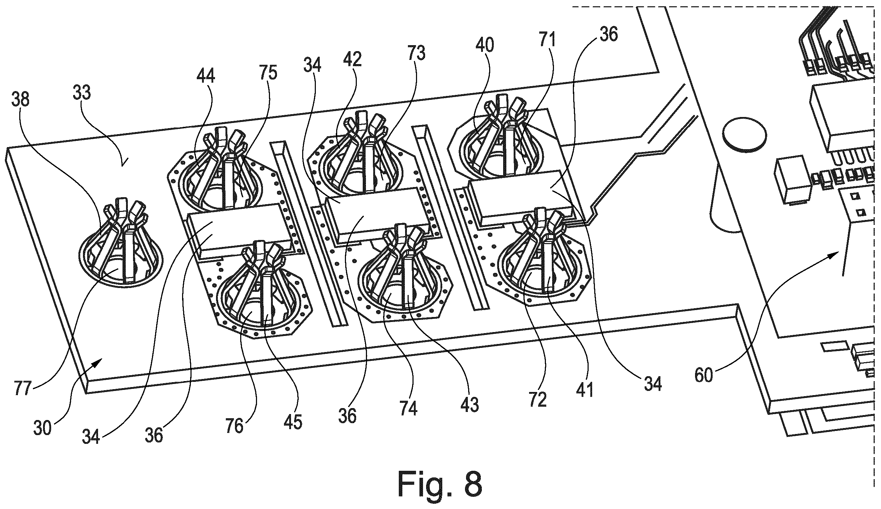

Figure 8 depicts the part of the PCB 30 of the electricity meter 10 where the meter connection terminals 38, 40, 41, 42, 43, 44, 45 and the orifices 71, 72, 73, 74, 75, 76, 77 are positioned. The orifices 71, 72, 73, 74, 75, 76, 77 are configured to be penetrated by corresponding connection terminals 138, 140, 141, 142, 143, 144, 145 of the electrical equipment 100. These orifices71, 72, 73, 74, 75, 76, 77 align with the neutral connection terminal 138, input phase connection terminals 140, 142, 144, and output phase connection terminals 141, 143, 145 of the electrical equipment 100. The neutral meter connection terminal 38, input phase meter connection terminals 40, 42, 44, and output phase meter connection terminals 41, 43, 45 are positioned coaxially with their respective orifices and are designed to protrude through these orifices when the electricity meter 10 is installed in the receiving section 120 of the electrical equipment 100.

The neutral meter connection terminal 38, input phase meter connection terminals 40, 42, 44, and output phase meter connection terminals 41, 43, 45 are formed as crown spring connectors, ensuring a secure and reliable electrical connection. These terminals are soldered to the PCB 30 on the side 31 facing away from the back surface 24 of the meter casing 20 and the receiving surface 122 of the electrical equipment 100.

The figure also depicts the at least one meter voltage sensor 34 and the at least one meter current sensor 36 housed within the meter casing 20. The meter current sensor 36 is implemented as an ammeter shunt, which is a precise method for measuring current flow. These meter sensors 34, 36 are allow for detecting and measuring the electrical parameters necessary for accurate power consumption metering.

Additionally, Figure 8 shows the meter data connection interface 60, which is configured to be connected to the data connection interface 160 of the electrical equipment 100. This connection is established by the same linear motion in the engagement direction ED towards the receiving section 120, ensuring that both electrical and data connections are made simultaneously during installation.

The network and system protection device 12 is housed within the meter casing 20, comprising the protection device processing unit 14 and the protection device voltage sensor 16. The protection device processing unit 14 is configured to control the switch pf the electrical equipment 100, which acts as a switch to disconnect the electrical equipment 100 from the main distribution grid based on voltage values measured by the protection device voltage sensor 16.

The embodiment includes redundant protection device processing units 14 and redundant protection device voltage sensors 16, enhancing the reliability and fault tolerance of the system. The meter housing 20 provides at least IP51 protection when installed in the electrical equipment 100, ensuring durability and resistance to environmental factors.

The electricity meter 10 is designed to meet certification standards according to the Measurement Instrument Directive MID, ensuring compliance with regulatory requirements. The detailed schematic representation in Figure 6 provides a comprehensive overview of the integration and operation of the system components, essential for professionals involved in installation, maintenance, or engineering of the device.

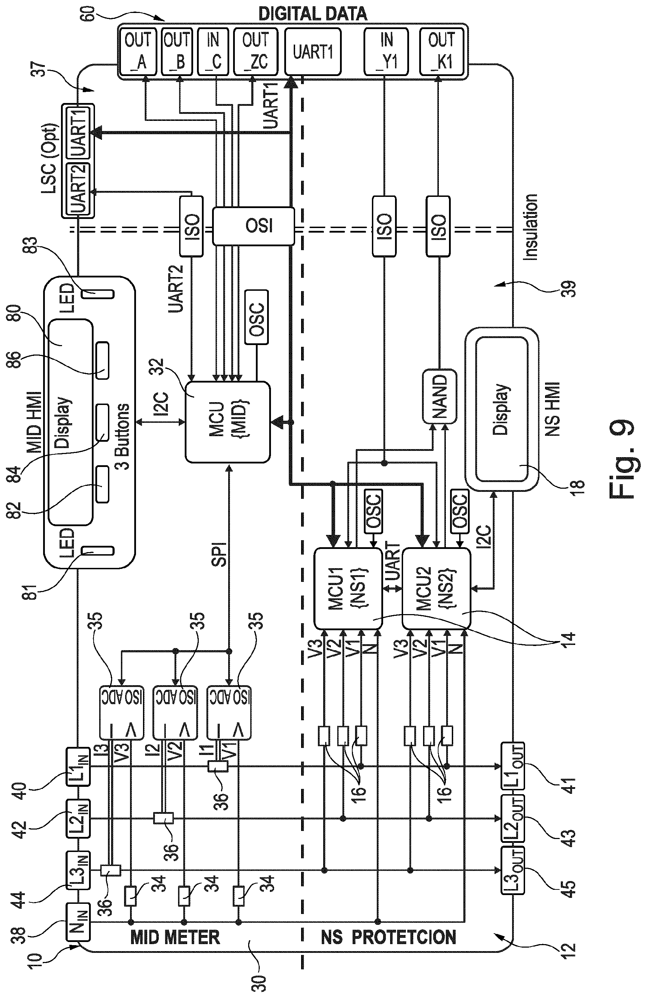

Figure 9 illustrates a schematic diagram of the electricity meter 10 according to the embodiment. The diagram provides a detailed view of the components and their interconnections within the system.

The electricity meter 10 comprises the meter processing unit 32, identified as MCU MID, which serves as the central control unit of the electricity meter 10. This meter processing unit 32 is responsible for managing data acquisition and processing from various sensors and interfaces. It is connected to multiple components via communication protocols such as UART1, UART2, and I2C, ensuring efficient data transmission and control. The electricity meter 10 further comprises at least one analog to digital converter 35, more particularly one analog to digital converter 35 for each current phase.

Meter voltage sensors 34 and meter current sensors 36 are integrated into the system to measure the electrical parameters necessary for metering. These sensors are connected to the meter processing unit 32 and to the respective analog to digital converter 35, allowing it to receive real-time data regarding voltage and current levels. The meter sensors 34, 36 are linked to input phase meter connection terminals 40, 42, and 44, as well as output phase meter connection terminals 41, 43, and 45. These terminals facilitate the connection of the electricity meter 10 to the electrical equipment 100, enabling accurate measurement of power consumption.

The schematic diagram also includes a neutral meter connection terminal 38, which is connected to the neutral line of the electrical equipment 100. This connection ensures the proper functioning of the electricity meter 10 and the accuracy of the measurements.

A meter screen unit 80 is incorporated into the system, providing a user interface for monitoring power consumption. The meter screen unit 80 is equipped with three buttons 82, 84, 86 for user interaction, allowing for navigation and configuration of the meter settings. Additionally, indicator lights 81 and 83 are present to indicate operational status and provide visual feedback to the user. Additionally, the network and system protection device 12 includes a second screen unit 18, providing information related to the network and system protection device 12's function.

The meter data connection interface 60 is shown at the top of the diagram, labeled as "DIGITAL DATA." This interface is designed for digital communication with external devices or systems, enabling the transmission of metering data for further processing or analysis.

The diagram is divided into sections by dashed lines labeled "Insulation," indicating areas of electrical isolation within the system. This design feature ensures safety and prevents interference between different components.

The diagram is further divided by a horizontal dashed line into two segments, namely a metering section 37 of the PCB 30 and a protection section 39 of the PCB 30, indicating areas of functional separation of the PCB 30 between the components of the electricity meter 10 responsible for metering and the components of the electricity meter 10 responsible for protection. More particularly, the meter processing unit 32, the meter voltage sensor(s) 34, the analog to digital converter(s) 35 and the meter current sensor(s) 36 are arranged on the metering section 37 of the PCB 30 and the device voltage sensor(s) 16 and the protection device processing unit 14 are arranged on the protection section 39 of the PCB 30. This design feature ensures safety and prevents interference between different components. It also ensures that the protection functionality operates separately from the metering functionality. Moreover, it allows for a separate certification of the metering function and the protection function. Furthermore, the electricity meter 10 may be certified before its installation in the electrical equipment 100, as for instance stipulated in Article 5 of the Measuring Instruments Directive 2014/32/EU.

Overall, Figure 9 provides a comprehensive view of the electricity meter's 10 architecture, highlighting the integration of meter sensors 34, 36, meter processing units 32, user interfaces, and connection terminals 38, 40, 41, 42, 43, 44, 45. The schematic emphasizes the linear motion connection mechanism, allowing for straightforward installation and engagement with the receiving section of the electrical equipment. This design facilitates ease of use and maintenance, making the meter suitable for various applications in power consumption metering.

The network and system protection device 12 is equipped with a memory unit, which stores information relative to the grid code of the main distribution grid. The protection device processing unit 14 has access to this memory unit, ensuring compliance with grid regulations.

A data interface is included in the network and system protection device 12, allowing communication with a configuration device. This interface facilitates the setup and adjustment of the protection device's parameters.

Redundancy is a particular feature of the network and system protection device 12, which includes at least two redundant protection device processing units 14 and at least two redundant protection device voltage sensors 16. Specifically, there are two redundant protection device voltage sensors 16 for each current phase, enhancing reliability and accuracy in voltage measurement.

In summary, figure 9 provides a detailed schematic representation of the electricity meter 10, highlighting its components, connections, and functionalities, particularly emphasizing the integration of the network and system protection device 12 within the meter casing 20.

## Claims

1. Electricity meter for metering a single phase power consumption or a three-phase power consumption of an electrical equipment (100), in particular of an electric vehicle supply equipment (EVSE) and configured to be installed in a receiving section (120) of the electrical equipment (100), the electricity meter (10) comprising a meter casing (20), a printed circuit board (PCB) (30) housed in the meter casing (20), a meter processing unit (32) soldered to the PCB (30), at least one meter voltage sensor (34) housed in the meter casing (20), at least one meter current sensor (36) housed in the meter casing (20), a neutral meter connection terminal (38) configured to be connected to a neutral connection terminal (138) of the electrical equipment (100) , at least one input phase meter connection terminal (40, 42, 44) configured to be connected to an input phase connection terminal (140, 142, 144) of the electrical equipment (100) and at least one output phase meter connection terminal (41, 43, 45) configured to be connected to an output phase connection terminal (141, 143, 145) of the electrical equipment (100), **characterized by** a network and system protection device (12) housed in the meter casing (20), the network and system protection device (12) comprising at least one protection device processing unit (14) and at least one protection device voltage sensor (16), the protection device processing unit (14) being configured to control a switch of the electrical equipment (100) based on a voltage value measured by the protection device voltage sensor (16) to disconnect the electrical equipment (100) from a main distribution grid.

2. Electricity meter according to claim 1, **characterized in that** the protection device processing unit (14) and the protection device voltage sensor (16) are soldered to the PCB (30), in particular to a section of the PCB (30) which is functionally independent of the meter processing unit (32), the meter voltage sensor (34) and the meter current sensor (36).

3. Electricity meter according to claim 1 or 2, **characterized by** a meter screen unit (80) configured to display the momentary power consumption of the electrical equipment (100), the network and system protection device (12) further comprising a second screen unit (18) configured to display information relative to the function of the network and system protection device (12).

4. Electricity meter according to any one of the claims 1 to 3, **characterized in that** the network and system protection device (12) further comprises a memory unit configured to store information relative to a grid code of the main distribution grid and to which the protection device processing unit (14) has access to.

5. Electricity meter according to any one of the claims 1 to 4, **characterized in that** the network and system protection device (12) further comprises a data interface , more particularly a wireless data interface, configured to communicate with a configuration device of the network and system protection device (12).

6. Electricity meter according to any one of the claims 1 to 5, **characterized in that** the network and system protection device (12) comprises at least two redundant protection device processing units (14).

7. Electricity meter according to any one of the claims 1 to 6, **characterized in that** the network and system protection device (12) comprises at least two redundant protection device voltage sensors (16), in particular two redundant protection device voltage sensors (16) for each current phase.

8. Electricity meter according to any one of the claims 1 to 7, **characterized in that** the meter housing (20) provides at least IP51 protection when installed in the electrical equipment (100).

9. Electricity meter according to any one of the claims 1 to 8, **characterized in that** the electricity meter (10) is an electricity meter which is certified according to the Measurement Instrument Directive (MID).

10. Electrical equipment, in particular an electric vehicle supply equipment (EVSE) comprising an electricity meter (10) according to any one of the claims 1 to 9, a receiving section (120), a neutral connection terminal (138), at least one input phase connection terminal (140, 142, 144) and at least one output phase connection terminal (141, 143, 145), the electricity meter (10) being installed in the receiving section (120), the neutral meter connection terminal (38) of the electricity meter (10) being connected to the neutral connection terminal (138), the input phase meter connection terminal (40, 42, 44) of the electricity meter (10) being connected to the input phase connection terminal (140, 142, 144) and the output phase meter connection terminal (41, 43, 45) of the electricity meter (10) being connected to the output phase connection terminal (141, 143, 145).
